(19) **Europäisches Patentamt**

**European Patent Office**

**Office européen des brevets**

(11) **EP 0 859 964 B1**

(12) **EUROPEAN PATENT SPECIFICATION**

(45) Date of publication and mention
of the grant of the patent:
**15.11.2006 Bulletin 2006/46**

(21) Application number: **97909239.2**

(22) Date of filing: **09.09.1997**

(51) Int Cl.:
***G01R 33/07*** (2006.01)

(86) International application number:
**PCT/EP1997/004932**

(87) International publication number:
**WO 1998/010302 (12.03.1998 Gazette 1998/10)**

(54) **METHOD FOR REDUCING THE OFFSET VOLTAGE OF A HALL DEVICE**

VERFAHREN ZUM REDUZIEREN DER OFFSETPANNUNG EINER HALLANORDNUNG

PROCEDE DE REDUCTION DE LA TENSION DE DECALAGE D'UN DISPOSITIF HALL

(84) Designated Contracting States:
**AT BE CH DE ES FR GB IT LI NL SE**

(30) Priority: **09.09.1996 US 25691 P**

(43) Date of publication of application:
**26.08.1998 Bulletin 1998/35**

(73) Proprietor: **AMS International AG**
**8141 Unterpremstätten (AT)**

(72) Inventors:
• **STEINER, Ralph**
**CH-8400 Winterthur (CH)**
• **HAEBERLI, Andreas**
**CH-8180 Bulach (CH)**
• **STEINER, Franz-Peter**
**CH-6430 Schwyz (CH)**

• **MAIER, Christoph**
**CH-8102 Oberengstringen (CH)**

(74) Representative: **Frei, Alexandra Sarah et al**
**Frei Patentanwaltsbüro**
**Postfach 1771**
**8032 Zürich (CH)**

(56) References cited:
**DE-A- 4 302 342      US-A- 4 037 150**
**US-A- 4 668 914**

• **MUNTER P J A: "ELECTRONIC CIRCUITRY FOR A SMART SPINNING-CURRENT HALL PLATE WITH LOW OFFSET" SENSORS AND ACTUATORS A, vol. A27, no. 1 - 03, 1 May 1991, pages 747-751, XP000216815**

Printed by Jouve, 75001 PARIS (FR)

## Description

### Field of the invention

The invention is in the field of integrated micro sensors, in particular sensors for measuring a magnetic field (Hall devices).

### Background of the invention

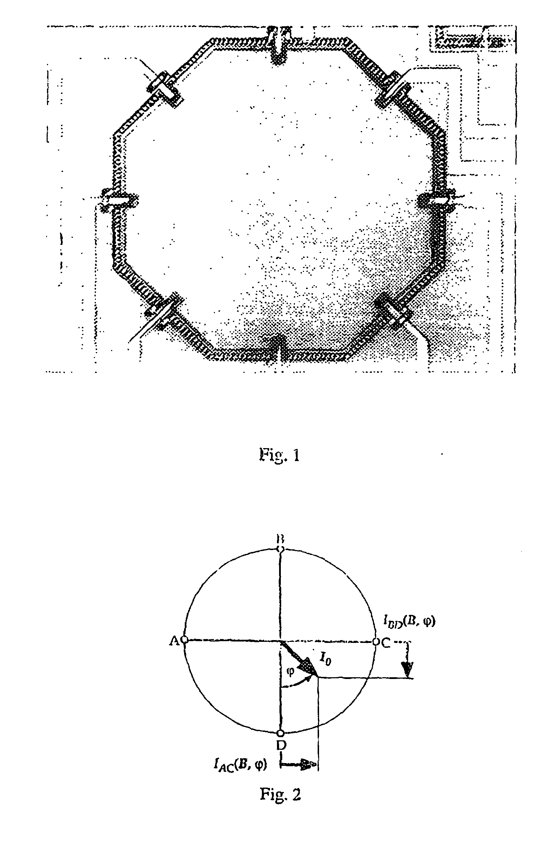

A Hall device usually has the form of a plate, but not necessarily. This plate consists of conducting material provided with at least four electrical contacts at its periphery. A bias current I is supplied to the device via two opposite contacts, called the current contacts. The two other contacts are placed at two equipotential points at the plate boundary. These contacts are called the voltage contacts or the sense contacts. If a magnetic field perpendicular to the surface is applied to the device, a voltage appears between the sense contacts due to the Hall effect. This voltage is called the Hall voltage. An example of a Hall device is shown in Fig. 1, where for the basic function only the contact pairs AC and BD are used.

A major problem of Hall devices is their offset voltage. The offset voltage is a static or a very low frequency output voltage at the sense contacts of the Hall device in the absence of a magnetic field. The causes of offset voltages in integrated Hall devices are imperfections of the fabrication process and nonuniformity of materials. An offset reduction method according to the state of the art is the switched spinning current method. This method uses a Hall plate with eight or more contacts which are symmetrical with respect to rotation by e.g. 45°. The direction of the current is made to spin discretely by contact commutation. Averaging the consecutive Hall voltages reduces the offset.

The object of the invention is to simplify and to generalize the switched spinning current method [1] and to further reduce the offset voltage.

### Summary of the invention

The inventive method serves for dynamically compensating the offset voltage of a Hall device. The Hall device can have either a platelike structure with a circular conductive area and at least four contacts arranged in pairs of opposite contacts on the circumference of the conductive area, the pairs of contacts being spaced from each other by equal spatial angles or it can have any form deriveable from such a circular arrangement by conformal mapping. It can e.g. be a so called vertical Hall device. The contact pairs are angled by e.g. 90°. Each pair is supplied with a periodically alternating current whereby the phase shift of the supply currents corresponds to the spatial phase shift of the contact pairs and is e.g. 90°. Superposition of the supplied currents results in a continuously spinning current vector in the Hall device. By measuring simultaneously the voltages between corresponding terminals, a signal consisting of the Hall voltage and a periodic offset voltage can be isolated. The offset voltage is eliminated by averaging the signal over at least one period. The advantages achieved compared to already existing methods are the following:

-   With state-of-the-art discretely spinning current schemes, the number of different current directions is limited to the number of terminals of the Hall device. The continuous spinning current method allows the use of more current settings than device terminals. Thus, aliasing effects as a consequence of discrete sampling can be reduced significantly. In the case of fully time-continuous spinning, these aliasing effects can be avoided completely.

-   Due to design constraints, Hall devices with more than four terminals increase in size, which makes them more susceptible to material inhomogeneity. The continuous spinning current method is applicable on minimal size Hall plates, and therefore, the lowest possible offset resulting from material inhomogeneity is achieved.

### Brief description of the drawings

Fig. 1     shows a micrograph of an eight-contact Hall plate in CMOS technology;

Fig. 2     shows a diagram of the two biasing currents $I_{AC}(B,\varphi)$, $I_{BD}(B,\varphi)$ and the resulting continuous spinning current vector $I_0$;

Fig. 3     shows the voltage drop $V_R$ due to $I_0$, its orthogonal part $V_{HO}(B,\varphi)$, and the projections $V_{AC}(B,\varphi)$ and $V_{BD}(B,\varphi)$;

Fig. 4 shows the current flow for the direction $\varphi = 0$, result of the biasing currents $I_{AC}(0) = 0$ and $I_{BD}(0) = I_0$;

Fig. 5 shows the flow of current for $\varphi = n/8$, result of the currents $I_{AC}(\pi/8) = 0.383I_0$ and $I_{BD}(\pi/8) = 0,923I_0$;

Fig. 6 shows the current flow for $\varphi = \pi/4$ which is the superposition of $I_{AC}(\pi/4) = 0.707I_0$ and $I_{BD}(\pi/4) = 0,707I_0$;

Fig. 7 shows a diagram of $V_{HO}$ versus the direction $\varphi$ of vector $I_0$ measured with switched spinning current ($\bullet$) and continuous spinning current ($\square$);

Fig. 8 shows a measurement setup with circuitry to control the substrate voltage $V_{sub}$, keeping the operating regime symmetric;

Fig.9 shows the sensitivity $S_a(I_{AC})$ with (o) and without (o) control circuitry. The full scale nonlinearity ($\pm$ 0.6 mA) is reduced to < 0.2%;

Fig. 10 shows the change of the remaining offset $V_o$ due to symmetric biasing conditions (with (o) and without (o) control circuitry);

Fig. 11 shows a block diagram of a circuit for measuring eight current settings with a four-terminal Hall plate.

**Description of the preferred embodiments**

A new method for dynamic compensation of the offset voltage in a four-terminal Hall device used as a magnetic sensor is presented. By applying a harmonic current at 0° and 90° phase angle, the nonperiodic Hall voltage can be separated from the spatially periodic offset voltage. Remaining offsets in the order of the earth magnetic field are achieved.
The presented method is implemented for a CMOS Hall device sensitive normal to the chip plane. A chip micrograph is shown in Fig. 1, whereby for the basic function only the contact pairs AC and BD are used. In this example, an n-well of 150 $\mu$m in diameter fabricated in a p-substrate constitutes the active area. The method, however, is not restricted to such a so-called lateral Hall device. Any Hall device arrangement that can be achieved by means of conformal mapping is suited, e.g. a vertical Hall device. In the case of a four-terminal Hall device, periodic biasing currents are applied to the contact pair AC and to the pair BD, with

$$I_{AC}(\varphi) = I_0 \cdot K(\varphi), \tag{1}$$

$$I_{BD}(\varphi) = I_0 \cdot L(\varphi), \tag{2}$$

whereby $I_0$ is the peak current $K(\varphi)$ and $L(\varphi)$ are periodic functions. This results in terminal voltages

$$V_{AC}(B,\varphi) = V_R K(\varphi) + V_{HO}(B,\varphi)L(\varphi) \tag{3}$$

and

$$V_{BD}(B,\varphi) = V_R L(\varphi) + V_{HO}(B,\varphi)K(\varphi) \tag{4}$$

which consist of a resistive part $V_R$ in phase with the current vector, and a superposition of the Hall and the offset voltage $V_{HO}(B,\varphi) = V_H(B) + V_O(\varphi)$, phase shifted by 90° with respect to the current. The Hall voltage with periodic offset is isolated from the resistive part by measuring a weighted sum of the voltages between corresponding terminals

$$V_{HO}(B,\varphi) \; = \; V_{AC}(B,\varphi)\lambda(\varphi) \; - \; V_{BD}(B,\varphi)\kappa(\varphi) \qquad\qquad (5)$$

with the periodic weight functions $\lambda(\varphi)$ and $\kappa(\varphi)$ satisfying the relations

$$\lambda(\varphi)\cdot L(\varphi) \; - \; \kappa(\varphi)\cdot K(\varphi) \; = \; 1 \text{ and } \kappa(\varphi)\cdot L(\varphi) \; + \; \lambda(\varphi)\cdot K(\varphi) \; = \; 0. \qquad (6)$$

In particular, if $-\kappa(\varphi) = K(\varphi) = \sin\varphi$ and $\lambda(\varphi) = L(\varphi) = \cos\varphi$, the currents applied to the contact pair AC and BD are sinusoids phase shifted by 90°:

$$I_{AC}(\varphi) \; = \; |I_0| \cdot \sin\varphi \qquad\qquad (7)$$

$$I_{BD}(\varphi) \; = \; |I_0| \cdot \cos\varphi. \qquad\qquad (8)$$

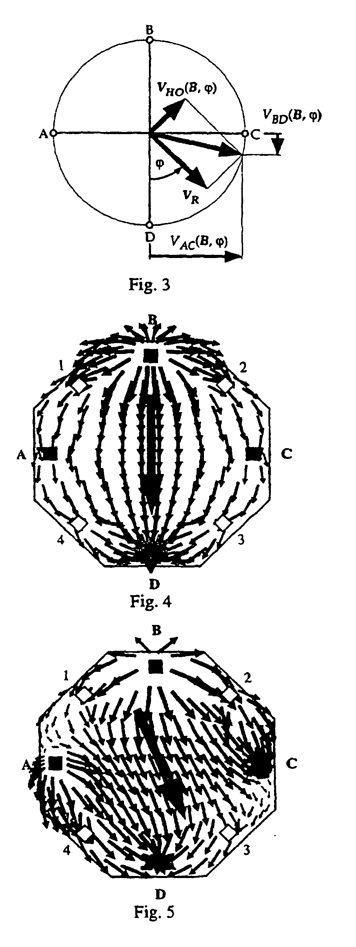

The superposition results in a continuous spinning current vector $I_0$ in the Hall probe (Fig. 2). The resulting voltages $V_R$ and $V_{HO}$ are shown in Fig. 3. From the voltages between corresponding terminals

$$V_{AC}(B,\varphi) \; = \; V_R\sin\varphi \; + \; V_{HO}(B,\varphi)\cos\varphi, \qquad\qquad (9)$$

$$V_{BD}(B,\varphi) \; = \; V_R\cos\varphi \; - \; V_{HO}(B,\varphi)\sin\varphi, \qquad\qquad (10)$$

the value of $V_{HO}(B,\varphi)$ is

$$V_{HO}(B,\varphi) \; = \; V_{AC}(B,\varphi)\cos\varphi \; - \; V_{BD}(B,\varphi)\sin\varphi. \qquad\qquad (11)$$

Averaging $V_{HO}(B,\varphi)$ over one period reduces the offset $V_O(\varphi)$ to its component independent of $\varphi$, which is negligible.

In Fig. 4 to Fig. 6, finite element simulations of the current flow are shown for different values of the direction $\varphi$. This sequence illustrates that the continuous spinning current method is a generalization of the switched method.

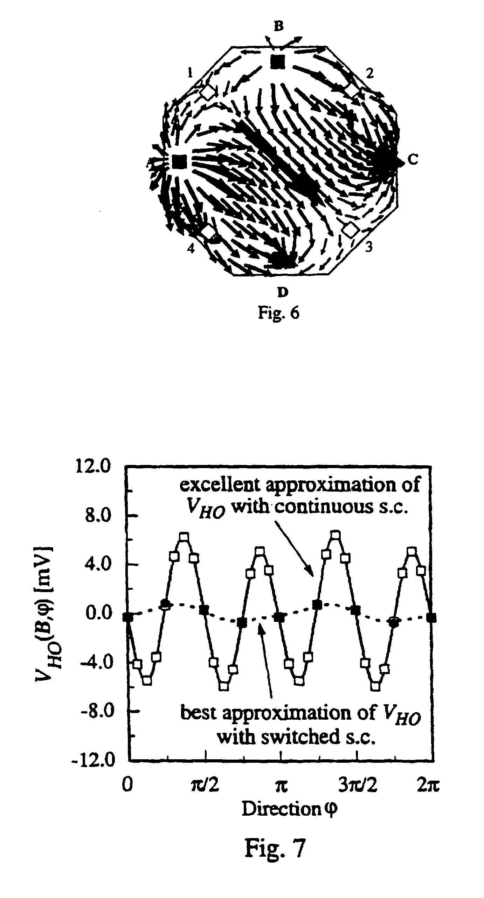

The signal $V_{HO}(B,\varphi)$ is continuously accessible, allowing a more detailed investigation of the offset behavior (Fig. 7) than the discrete sampling method described in [1]. To evaluate the remaining offset voltage $V_O = V_{HO}(0,\varphi)$, however, a limited number of measurements per period such as $\varphi = 2\pi n/N$ with $n \, \varepsilon \, \{1 ... N\}$ is sufficient for a substantial offset reduction. With increasing number of measurement points $V_O$ decreases since aliasing effects are reduced according to the sampling theorem. Using the absolute sensitivity $S_a$, the equivalent offset $B_O = V_O/S_a$ is calculated to be less than 0.1 Gauss (10 $\mu$T).

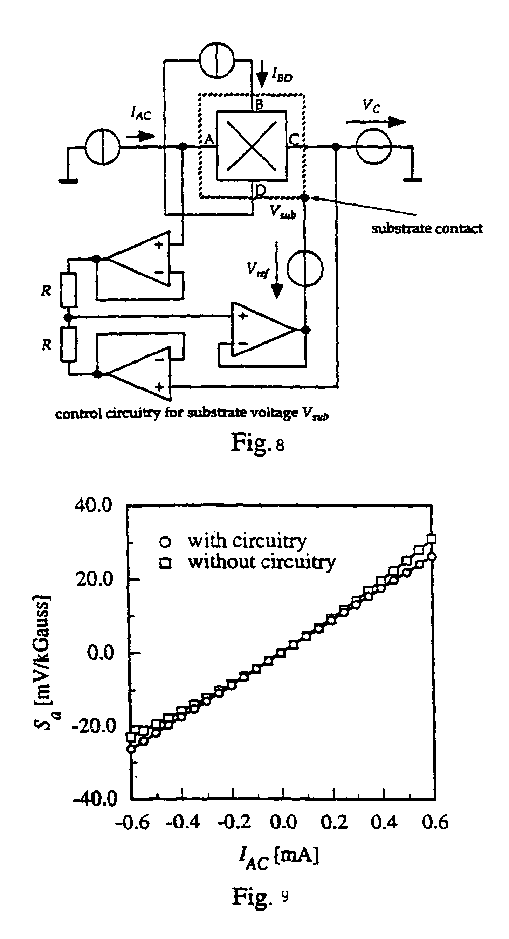

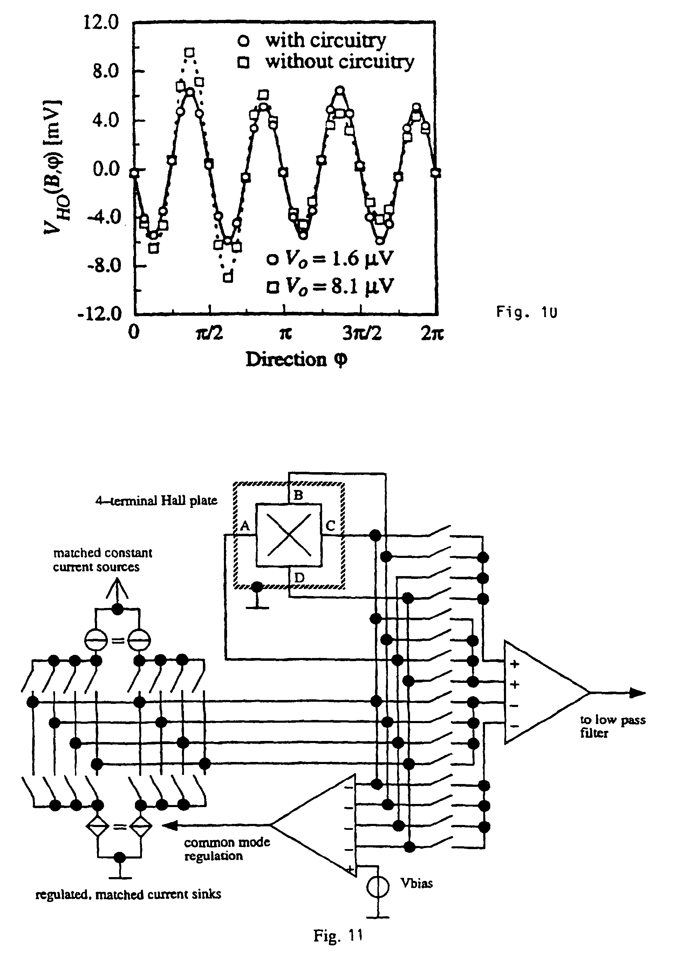

The setup used for the measurements is shown in Fig. 8. The control circuitry keeps the voltage difference between the center of the Hall device and the substrate at a constant value. The sensitivities $S_a(I_{AC})$ and $S_a(I_{BD})$ (Fig. 9) become linear functions; consequently, no higher harmonics of $V_H(B) = S_a \cdot |B|$ are generated. Additionally, the Hall device is biased symmetrically, resulting in lower remaining offsets $V_O$ (Fig. 10).

The inventive method constitutes an improved concept for dynamic offset reduction. The present error sources (limited accuracy of controlling the substrate voltage, limited accuracy of measuring biasing currents and resulting voltages) are improved by on-chip circuitry.

Figure 11 shows an embodiment of a circuit which allows to measure the Hall voltage of eight current settings with a Hall plate with only four contacts, which permits the design of a small Hall plate, yet reduces the offset significantly (see Fig. 7). The circuit consists of two matched current sources and two regulated matched current sinks (left), which can be switched to each of the terminals of the Hall plate. An integrating amplifier (right in the Figure) evaluates the difference voltages appropriate for extracting the Hall voltage. By an appropriate sequence of switch settings, the currents applied are

$$I_{AC} = \{0,I,2I,I,0,-I,-2I,-I\} \text{ and } I_{BD} = \{2I,I,0,-I,-2I,-I,0,I\} \qquad .(12)$$

The voltages at the four contacts are evaluated with the sequence

$$V_{HO} = \text{mean } \{V_A\text{-}V_C, (V_D\text{-}V_C)+(V_A\text{-}V_B), V_D\text{-}V_B, (V_D\text{-}V_A)+(V_C\text{-}V_B),$$
$$V_C\text{-}V_A, (V_B\text{-}V_A)+(V_C\text{-}V_D), V_B\text{-}V_D, (V_B\text{-}V_C)+(V_A\text{-}V_D)\}. \qquad (13)$$

This can be implemented by simple switches, an amplifier and a low-pass filter. For control of the bias voltage of the Hall plate, one of the matched pairs is regulated by the common-mode voltage of all four Hall plate contacts, while the other pair is used as current reference.

**References:**

[1] A. A. Bellekom and P. J. A. Munter, "Offset Reduction in Spinning Current Hall Plates," Sensor and Materials 5, 253, 1994.

**Claims**

1. Method for reducing the offset of a Hall device having a circular conductive area and at least four contacts (A, B, C, D) arranged in pairs (A/B, C/D) of opposite contacts on the circumference of the conductive area, the pairs of contacts being spaced from each other by equal spatial angles or having a conductive area and contact pairs derived by conformal mapping from said circular area, which method comprises the steps of

   - applying a current ($I_0$) to the conductive area whereby the direction of the current is rotated within the area,
   - measuring the voltage difference across the conductive area perpendicular to the current ($I_0$),
   - and averaging the voltage differences measured during at least one rotation period,

   **characterized**

   - **in that** the rotating current is generated by applying to each contact pair an alternating current whereby the frequency of the currents applied to all contact pairs is the same and the phase shift between the currents applied to contact pairs corresponds to the spatial angle between the same contact pairs.

2. Method according to claim 1, **characterized in that** the voltage between the center of the conductive area of the Hall device and a substrate on which the Hall device is constructed is kept constant.

3. Method according to claim 1 or 2, **characterized in that** the voltage differences are sampled at angles for current $2\pi n/N$ with respect to a direction in the plane of the current flow whereby n and N are integers and n is 0 .... N and **in that** the Hall voltage is calculated from a weighted sum of measured voltages at the contacts.

4. Method according to one of claims 1 to 3, **characterized in that** the Hall device comprises two pairs of contacts (A/C and B/D) spaced from each other by spatial angles of 90°.

5. Method according to claims 3 and 4, **characterized in that** the currents ($I_{AC}$, $I_{BD}$) applied to the pairs of contacts are increased and decreased in equal steps spaced from each other by a phase angle of $\pi/4$ whereby alternating currents of the form (0, I, 21, I, 0, -1. -21, -I) are generated.

6. Method according to claim 5, **characterized in that** the voltages of the four contacts ($V_A$, $V_B$, $V_C$, $V_D$) are sampled between the current steps and **in that** the voltage differences are calculated in the sequence $V_A$-$V_C$ for $I_{AC}$ = 0 and $I_{BD}$ = 2I, followed by ($V_D$-$V_C$)+($V_A$-$V_B$), $V_D$-$V_B$, ($V_D$-$V_A$)+($V_C$-$V_B$), $V_C$-$V_A$, ($V_B$-$V_A$)+($V_C$-$V_D$), $V_B$-$V_D$, ($V_B$-$V_C$)+($V_A$-$V_D$).

7. Hall device operated by the method according to one of claims 1 to 6, **characterized in that** it is an integrated device constructed on a silicon substrate and that the circuitry for supplying the currents to the contact pairs and for sampling and averaging the voltages is implemented on the same substrate.

8. Hall device according to claim 7, **characterized in that** it has four contacts (A, B, C, D) spaced from each other by 90°.

9. Hall device according to claim 8, **characterized in that** the circuitry comprises a matched pair of current sinks and a matched pair of current sources, the sinks and the sources being independently switchable to the four contacts (A, B, C, D) of the Hall device.

10. Hall device according to one of claims 7 to 9, **characterized in that** the conductive area lies within the plane of the substrate or is perpendicular to the plane of the substrate.


**Patentansprüche**

1. Verfahren zum Verringern des Offset einer Hall-Vorrichtung mit einem kreisförmigen leitenden Bereich und wenigstens vier Kontakten (A, B, C, D), die in Paaren (A/B, C/D) von gegenüber liegenden Kontakten an dem Außenumfang des leitenden Bereichs angeordnet sind, wobei die Kontaktpaare durch gleiche räumliche Winkel von einander beabstandet sind, oder mit einem leitenden Bereich und Kontaktpaaren, die durch konforme Abbildung von dem kreisförmigen Bereich erhalten werden, welches Verfahren die Schritte umfasst:

   - Anlegen eines Stromes ($I_0$) an den leitenden Bereich, wodurch die Richtung des Stromes innerhalb des Bereichs gedreht wird,
   - Messen des Spannungsunterschieds über dem leitenden Bereich senkrecht zu dem Strom $I_0$, und
   - Mitteln der während wenigstens einer Drehperiode gemessenen Spannungsunterschiede ($I_0$),

   **kennzeichnet**

   - **dadurch, dass** der sich drehende Strom erzeugt wird, indem an jedes Kontaktpaar ein Wechselstrom angelegt wird, wodurch die Frequenz der an alle Kontaktpaare angelegten Ströme gleich ist und die Phasenverschiebung zwischen den an Kontaktpaaren angelegten Strömen dem räumlichen Winkel zwischen den gleichen Kontaktpaaren entspricht.

2. Verfahren nach Anspruch 1, **dadurch gekennzeichnet, dass** die Spannung zwischen dem Mittelpunkt des leitenden Bereichs der Hall-Vorrichtung und einem Substrat, auf dem die Hall-Vorrichtung aufgebaut ist, konstant gehalten wird.

3. Verfahren nach Anspruch 1 oder 2, **gekennzeichnet, dadurch dass** die Spannungsunterschiede unter Stromwinkeln von $2\pi n/N$ relativ zu einer Richtung in der Ebene des Stromflusses erfasst werden, wodurch n und N ganze Zahlen sind und n 0 ... N beträgt, und **dadurch**, dass die Hall-Spannung aus einer gewichteten Summe gemessener Spannungen an den Kontakten berechnet wird.

4. Verfahren nach einem der Ansprüche 1 bis 3, **dadurch gekennzeichnet, dass** die Hall-Vorrichtung zwei Kontaktpaare (A/B und C/D) umfasst, die durch einen räumlichen Winkel von 90° von einander beabstandet sind.

5. Verfahren nach den Ansprüchen 3 und 4, **dadurch gekennzeichnet, dass** die Ströme ($I_{AC}$, $I_{BD}$), die an die Kontaktpaare angelegt werden, in gleichen Schritten erhöht und verringert werden, die durch einen Phasenwinkel von $\pi/4$ von einander beabstandet sind, wodurch Wechselströme der Form (0, I, 2I, I, 0, -I, -2I, -I) erzeugt werden.

6. Verfahren nach Anspruch 5, **gekennzeichnet, dadurch dass** die Spannungen der vier Kontakte ($V_A$, $V_B$, $V_C$, $V_D$)

zwischen den Stromschritten erfasst werden und **dadurch** dass die Spannungsunterschiede in der Folge $V_A$ - Vc für $I_{AC}$ = 0 und $I_{BD}$ = 2I gefolgt von $(V_D - V_C) + (V_A - V_B)$, $V_D - V_B$, $(V_D - V_A) + (V_C - V_B)$, $V_C - V_A$, $(V_B - V_A) + (V_C - V_D)$, $V_B - V_D$, $(V_B - V_C) + (V_A - V_D)$ berechnet werden.

7.  Hall-Vorrichtung, gemäß dem Verfahren nach einem der Ansprüche 1 bis 6 betrieben, **dadurch gekennzeichnet dadurch**, dass sie eine integrierte Vorrichtung ist, die auf einem Siliziumsubstrat aufgebaut ist und dass die Schaltkreisanordnung, um den Kontaktpaaren die Ströme zuzuführen und um die Spannungen zu erfassen und zu mitteln, auf dem gleichen Substrat implementiert ist.

8.  Hall-Vorrichtung nach Anspruch 7, **dadurch gekennzeichnet, dass** sie vier Kontaktpaare (A, B, C, D) aufweist, die um 90° von einander beabstandet sind.

9.  Hall-Vorrichtung nach Anspruch 8, **dadurch gekennzeichnet, dass** die Schaltkreisanordnung ein abgestimmtes Paar an Stromsenken und ein abgestimmtes Paar an Stromquellen umfasst, wobei die Senken und Quellen unabhängig mit den vier Kontakten (A, B, C, D) der Hall-Vorrichtung verbindbar sind.

10. Hall-Vorrichtung nach einem der Ansprüche 7 bis 9, **dadurch gekennzeichnet, dass** der leitende Bereich innerhalb der Ebene des Substrats liegt oder sich senkrecht zu der Ebene des Substrats befindet.

## Revendications

1.  Procédé de réduction du décalage d'un dispositif Hall possédant une zone conductrice circulaire et au moins quatre contacts (A, B, C, D) agencés par paires (A/B, C/D) de contacts opposés sur la circonférence de la zone conductrice, les paires des contacts étant espacées les unes des autres par des angles spatiaux égaux ou possédant une zone conductrice circulaire et des paires de contacts dérivées par transformation conforme de ladite zone circulaire, lequel procédé comprend des étapes de :

    application d'un courant ($I_0$) à la zone conductrice, le sens du courant tournant à l'intérieur de la zone ;
    mesure de la différence de tension à travers la zone conductrice perpendiculairement au courant ($I_0$) et
    calcul de la moyenne des différences de tension mesurées au cours d'au moins une période de rotation,

    **caractérisé en ce que** le courant rotatif est généré en appliquant à chaque paire de contacts un courant alternatif alors que la fréquence des courants appliqués à toutes les paires de contacts est la même et que le déphasage entre les courants appliqués aux paires de contacts correspond à l'angle spatial formé entre les mêmes paires de contacts.

2.  Procédé selon la revendication 1, **caractérisé en ce que** la tension entre le centre de la zone conductrice du dispositif Hall et un substrat sur lequel le dispositif Hall est construit reste constante.

3.  Procédé selon la revendication 1 ou 2, **caractérisé en ce que** les différences de tension sont échantillonnées en certains angles pour un courant de 2 $\Pi$n/N par rapport à un sens dans le plan de la circulation du courant, où n et N sont des entiers et où n est 0 .... N et **en ce que** la tension Hall est calculée à partir d'une somme pondérée des tensions mesurées au niveau des contacts.

4.  Procédé selon l'une quelconque des revendications 1 à 3, **caractérisé en ce que** le dispositif Hall comprend deux paires de contacts (A/C et B/D) espacées les unes des autres par des angles spatiaux de 90 °.

5.  Procédé selon les revendications 3 et 4, **caractérisé en ce que** les courants ($I_{AC}$, $I_{BD}$) appliqués aux paires de contacts augmentent et diminuent par paliers égaux espacés les uns des autres d'un angle de phase de $\Pi/4$, où des courants alternatifs de la forme (0, I, 2I, I, 0, -I, - 2I, -I) sont générés.

6.  Procédé selon la revendication 5, **caractérisé en ce que** les tensions des quatre contacts ($V_A$, $V_B$, $V_C$, $V_D$) sont échantillonnées entre les paliers de courant et **en ce que** les différences de tension sont calculées selon la série $V_A$-$V_C$ pour $I_{AC}$ = 0 et $I_{BD}$ = 2I, suivie de $(V_D$-$V_C) + (V_A$-$V_B)$, $V_D$-$V_B$, $(V_D$-$V_A) + (V_C$-$V_B)$, $V_C$-$V_A$, $(V_B$-$V_A) + (V_C$-$V_D)$, $V_B$-$V_D$, $(V_B$-$V_C) + (V_A$-$V_D)$.

7.  Dispositif Hall actionné grâce au procédé selon l'une quelconque des revendications 1 à 6, **caractérisé en ce qu'**il s'agit d'un dispositif intégré construit sur un substrat de silicone et **en ce que** la circuiterie fournissant les courants aux paires de contacts et permettant d'échantillonner et de calculer la moyenne des tensions est mise en oeuvre à partir du même substrat.

8. Dispositif Hall selon la revendication 7, **caractérisé en ce qu'**il possède quatre contacts (A, B, C, D) espacés les uns des autres de 90°.

9. Dispositif Hall selon la revendication 8, **caractérisé en ce que** le circuit comprend une paire correspondante de collecteurs de courant et une paire correspondante de sources de courant, les collecteurs et les sources pouvant être indépendamment commutés aux quatre contacts (A, B, C, D) du dispositif Hall.

10. Dispositif Hall selon l'une quelconque des revendications 7 à 9, **caractérisé en ce que** la zone conductrice se trouve à l'intérieur du plan du substrat ou est perpendiculaire au plan du substrat.

Fig. 1

Fig. 2

Fig. 3

Fig. 4

Fig. 5

Fig. 6

Direction φ

Fig. 7

control circuitry for substrate voltage $V_{sub}$

**Fig. 8**

**Fig. 9**

Fig. 10

Fig. 11